**Europäisches Patentamt**

**European Patent Office**

**Office européen des brevets**

(11) Veröffentlichungsnummer: **0 256 271**
**A1**

(12) # EUROPÄISCHE PATENTANMELDUNG

(21) Anmeldenummer: **87109466.0**

(22) Anmeldetag: **01.07.87**

(51) Int. Cl.⁴: **B25J 19/02 , H05K 13/00**

(30) Priorität: **15.07.86 DE 3623884**

(43) Veröffentlichungstag der Anmeldung:
**24.02.88 Patentblatt 88/08**

(84) Benannte Vertragsstaaten:
**AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Früh, Walter, Dipl.-Ing.**
**Albert-Schweitzer-Strasse 54**
**D-8000 München 83(DE)**
Erfinder: **Schnorrenberg, Hans-Jürgen**
**Schleibingerstrasse 1**
**D-8000 München 83(DE)**

(54) **Verfahren und Vorrichtung zur Feinjustierung eines Objektes auf einer Teilfläche einer Ebene.**

(57) Verfahren und Vorrichtung zur Feinjustierung eines Objektes mittels einer fernbedienbaren Haltevorrichtung (5) auf einer Teilfläche einer Ebene, nach dem Prinzip der Reflexionsabtastung. Hiermit wird ermöglicht, daß Objekte wie Werkzeuge oder Abtastspitzen (3) auf der Leiterplatte (4) im Rahmen der Genauigkeit der Ätzung und der Bohrung feinjustiert werden.

EP 0 256 271 A1

## Verfahren und Vorrichtung zur Feinjustierung eines Objektes auf einer Teilfläche einer Ebene.

Die Erfindung betrifft ein Verfahren zur Feinjustierung eines Objektes mittels einer fernbedienbaren Haltevorrichtung auf einer Teilfläche einer Ebene.

Durch die zunehmende Miniaturisierung bei elektronischen Baugruppen entsteht ein immer höherer Bedarf an Vorrichtungen zur Feinjustierung, um genaue Positionierungsaufgaben auf den Baugruppen durchführen zu können. Dies zeigt sich auch im Bereich der Leiterplattenentwicklung, die heute im wesentlichen mit automatischen Layoutsystem entwickelt werden. In den Dateien der Layoutsysteme sind alle Daten, die eine Leiterplatte vollständig beschreiben gespeichert, diese Informationen werden in den heutigen Justiersystemen ausgenutzt. Zu diesen Informationen zählen unter anderem Daten über das Leiterbahnbild, über die Bohrungen auf der Leiterplatte, über die Bestückung, über die Ätz-und Löttoleranzen. Positionierungsaufgaben exisitieren nicht nur in der Leiterplattenentwicklung sondern auch in der Prüfung von elektronischen Baugruppen. Hier müssen Tastspitzen über der Leiterplatte positioniert werden, um anschließend interne Punkte auf der Baugruppe zu kontaktieren.

Es ist bekannt, daß bisherige Justiersystem mit mehrstufiger Justierung arbeiten. In der ersten Stufe wird eine mechanische Grobjustierung und in der zweiten Stufe eine Feinjustierung vorgenommen und über ein Mikroskop oder eine Fernseheinrichtung der Justiervorgang beobachtet. Der Justiervorgang wird mit Hilfe von fernbedienbaren Haltevorrichtungen, sogenannten Manipulatoren, durchgeführt.

Eine solche Methode zur Feinjustierung entzieht sich weitgehend der Automatisierung, da der Mensch die Auswertung über die Feinjustierung mit Hilfe des Mikroskops und einer Fernseheinrichtung selbst vornimmt.

Der Erfindung liegt die Aufgabe zugrunde, Objekte mit Hilfe einer fernbedienbaren Haltevorrichtung schnell und automatisch auf vorgegebene Teilflächen oder Punkte einer Ebene zu positionieren.

Die Aufgabe wird erfindungsgemäß dadurch gelöst, daß mindestens ein Sender elektromagnetische Wellen auf die Ebene abstrahlt und mindestens ein Empfänger die auf der Ebene reflektierten Wellen empfängt und auswertet und in Abhängigkeit der Auswertung die Feinjustierung des Objektes durchführt.

Aufgrund der Forderung nach einer schnellen automatischen Positionierung und der anzunehmenden hohen Anzahl der vorgegebenen Flächen oder Punkte erfolgt die Auswertung in einer DV-Anlage, indem die empfangenen reflektierten Wellen mit gespeicherten Informationen über die Ebene verglichen werden, hieraus ein Differenzsignal gebildet wird und hiermit das Objekt über eine fernbedienbare Haltevorrichtung feinjustiert wird.

Um eine hohe Empfindlichkeit bei der Vorrichtung zum Durchführen eines solchen Verfahrens zu erzielen hat zum einen der Sender eine monochromatische Lichtquelle und der Empfänger ist auf die Wellenlänge des monochromatischen Lichtes des Senders abgestimmt, zum andern hat die monochromatische Lichtquelle eine Wellenlänge, die ein stark unterschiedliches Reflexions-und Absorptionsverhalten auf Materialien der Ebene hat.

Bei der Layout-Entwicklung oder bei der Prüfung der elektronischen Baugruppen ist die Ebene eine Leiterplatte und die Materialien auf der Leiterplatte sind Kupfer, Epoxid und Lötzinn, das Objekt hingegen ist eine Tastspitze und die Teilfläche ein Abtastpunkt, Sender und Empfänger sind als Abtastpaar und mehrere Abtastpaare zu einer Matrix aufgebaut, bei der im Zentrum die Tastspitze angeordnet ist.

Die mit der Erfindung erzielten Vorteile bestehen insbesondere darin, daß das Verfahren und die Vorrichtung universell anwendbar ist. Die Vorrichtung ist nicht nur auf Leiterplatten beschränkt, auf denen positioniert wird. Sie kann ebenso auf die VLSI-Entwicklung und auf große Anordnungen, wie sie in der Mechanik üblich sind, eingesetzt werden. Die Genauigkeit der Positionierung ist nur von der Genauigkeit der optischen Definition des Positionierungspunktes auf der Leiterplatte abhängig. Da die objektnahen Teile der Vorrichtung wie beispielsweise Sende-und Empfangsdiode klein sind und über hochflexible Glasfaserbündel mit der restlichen Vorrichtung verbunden sein können, können die objektnahen Teile in die verschiedensten Anordnungen beispielsweise in Kühlplatten integriert werden.

Die Erfindung wird anhand eines Ausführungsbeispiels im folgenden näher beschrieben. Es zeigt

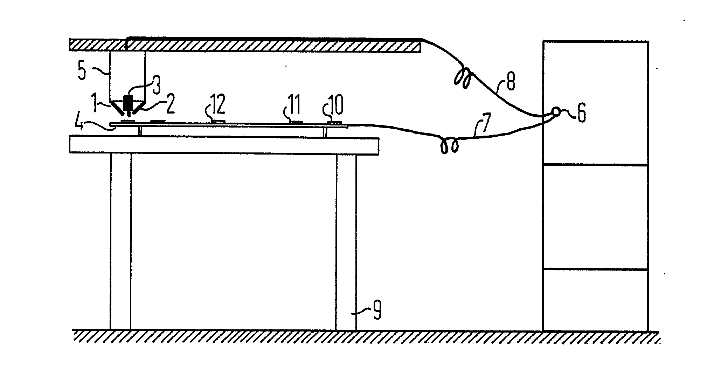

Figur 1 ein Ausführungsbeispiel aus der Baugruppen-Prüfung zum Durchführen des Verfahrens.

Die Figur 1 zeigt die fernbedienbare Haltevorrichtung 5, die die objektnahen Teile wie Sender 1, Empfänger 2 und Tastspitze 3 über die Leiterplatte 4 bewegt. Die Leiterplatte 4 ist auf dem Koordinatentisch 9 aufgelegt und trägt verschiedene Baugruppen 10, 11, 12. Die Leiterplatte 4, die objektnahen Teile 1, 2, 3 und die fernbedienbare Haltevorrichtung 5 sind über Verbindungsleitungen 7, 8 mit einer DV-Anlage 6 verbunden. Über die Verbindungsleitungen 7 werden die Baugruppen 10, 11, 12 auf der Leiterplatte 4 mit der erforderlichen Versorgungsspannung und den Testsignalen versorgt und das erste Ausgangssignal gemessen. Bei einem fehlerfreien Meßwert wird das nächste Ausgangssignal gemessen, solange bis alle Meßwerte aufgenommen wurden. Bei einem fehlerhaften Meßwert, gibt das Fehlerdiagnoseprogramm in der DV-Anlage 6 die Koordinaten des zu kontaktierenden Punktes auf der Leiterplatte 4 an. Es erfolgt eine Grobjustierung des Tastkopfes 3 mittels der fernbedienbaren Haltevorrichtung 5 nach dem Koordinaten des Fehlerdiagnoseprogramms. Die vom Sender 1 abgestrahlten reflektierten elektromagnetischen Wellen werden im Empfänger 2 aufgenommen und es wird ein abgetastetes Bild erstellt. Anschließend erfolgt ein Vergleich zwischen den gespeicherten Informationen in der DV-Anlage 6 über den zu kontaktierenden Punkt und dem abgetasteten Bildpunkt. Bei einer Abweichung zwischen dem abgetasteten Bild und den gespeicherten Informationen erfolgt die Feinjustierung des Tastkopfes mittels der fernbedienbaren Haltevorrichtung 5 durch die erfindungsgemäße Vorrichtung. Die Feinjustierung ist dann beendet, wenn das abgetastete Bild mit den gespeicherten Informationen übereinstimmt. Nach Messung des kontaktierten Punktes mit der Tastspitze 3 wird der nachfolgende durch das Fehlerdiagnoseprogramm angegebene Koordinatenpunkt angesteuert, feinjustiert und gemessen. Dieser Vorgang wiederholt sich so oft, bis der Fehler gefunden worden ist.

Bezugszeichenliste

1 Sender
2 Empfänger
3 Abtastspitze
4 Leiterplatte
5 ferngesteuerte Haltevorrichtung
6 DV-Anlage
7, 8 Verbindungsleitungen
9 Korrodinatentisch
10, 11, 12 Baugruppen auf der Leiterplatte 4

**Ansprüche**

1. Verfahren zur Feinjustierung eines Objektes mittels einer fernbedienbaren Haltevorrichtung (5) auf einer Teilfläche einer Ebene, **dadurch gekennzeichnet,** daß mindestens ein Sender (1) elektromagnetische Wellen auf die Ebene abstrahlt und mindestens ein Empfänger (2) die auf der Ebene reflektierten Wellen empfängt und auswertet und in Abhängigkeit der Auswertung die Feinjstierung des Objektes durchführt.

2. Verfahren nach Anspruch 1, **dadurch gekennzeichnet,** daß die Auswertung in einer DV-Anlage (6) erfolgt, in dem die empfangenen reflektierten Wellen mit gespeicherten Informationen über die Ebene verglichen werden, hieraus ein Differenzsignal gebildet wird und hiermit das Objekt über eine fernbedienbare Haltevorrichtung (5) feinjustiert wird.

3. Vorrichtung zum Durchführen des Verfahrens nach Anspruch 2, **dadurch gekennzeichnet,** daß der Sender (1) eine monochromatische Lichtquelle hat und der Empfänger (2) auf die Wellenlänge des monochromatischen Lichtes des Senders (1) abgestimmt ist.

4. Vorrichtung nach Anspruch 3, **dadurch gekennzeichnet,** daß die monochromatische Lichtquelle eine Wellenlänge hat, die ein stark unterschiedliches Reflextions-und Absorptionsverhalten auf Materialien der Ebene hat.

5. Vorrichtung nach Anspruch 4, **dadurch gekennzeichnet,** daß die Ebene eine Leiterplatte (4) ist und die Materialien auf der Leiterplatte (4) Kupfer, Epoxid oder Lötzinn sind.

6. Vorrichtung nach Anspruch 4 oder Anspruch 5, **dadurch gekennzeichnet,** daß das Objekt eine Tastspitze (3) und die Teilfläche ein Abtastpunkt ist und Sender (1) und Empfänger (2) als Abtastpaar und mehrere Abtastpaare zu einer Matrix aufgebaut sind, bei der im Zentrum die Tastspitze (3) angeordnet ist.

0 256 271

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 007 097  (SHELLEY et al.) * Spalte 1, Zeile 38 - Spalte 2, Zeile 3; Spalte 4, Zeilen 54-64; Spalte 5, Zeile 20 - Spalte 7, Zeile 57; Figuren 1, 6-8 * | 1 | B 25 J  19/02 H 05 K  13/00 |
| A | | 3,4 | |
| | --- | | |
| X | IBM TECHNICAL DISCLOSURE BULLETIN, vol. 27, no. 1A, June 1984, pages 218-221; F. MUIR et al.: "Local sensor to improve probe accuracy" * gesamtes Dokument * | 1,2 | |
| A | idem | 5 | |
| | | | RECHERCHIERTE SACHGEBIETE (Int. Cl.4) |
| | --- | | |
| X | GB-A-2 087 107  (UNIMATION INC.) * Zusammenfassung; Seite 1, Zeile 119 - Seite 2, Zeile 38; Seite 3, Zeilen 14-98; Anspruch 1; Figuren 1, 2, 6 * | 1,2 | G 05 D B 25 J H 05 K B 23 Q H 01 L G 06 F |
| | --- | | |
| X | US-A-3 888 362  (FLETCHER et al.) *  Zusammenfassung;  Spalte 3, Zeile 26 - Spalte 4, Zeile 9; Spalte 8, Zeile 18 - Spalte 9 Zeile 38; Figuren 1-7 * | 1 | |
| | ---              -/- | | |

Der vorliegende Recherchenbericht wurde für alle Patentansprüche erstellt.

| Recherchenort | Abschlußdatum der Recherche | Prüfer |
|---|---|---|
| BERLIN | 23-10-1987 | BEITNER M.J.J.B. |

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | --- | 3,4,6 | |
| A | EP-A-0 134 573 (IBM) * Zusammenfassung; Seite 6, Zeile 2 - Seite 7, Zeile 19; Figur 1 * --- | 1,2 | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| BERLIN | 23-10-1987 | BEITNER M.J.J.B. |